# EUROPÄISCHE PATENTSCHRIFT

(11) **EP 3 328 574 B1**
(45) Veröffentlichungstag und Bekanntmachung des Hinweises auf die Patenterteilung: **21.08.2019**
(21) Anmeldenummer: 16757143.9
(22) Anmeldetag: 27.07.2016
(51) Int. Cl.: B22D 11/06, C22C 21/00, B22D 11/00

(54) **VERFAHREN ZUR HERSTELLUNG EINER MONOTEKTISCHEN LEGIERUNG**
METHOD FOR PRODUCING A MONOTECTIC ALLOY
PROCÉDÉ DE PRODUCTION D'UN ALLIAGE MONOTECTIQUE

(30) Priorität: 30.07.2015 DE 102015112550
(43) Veröffentlichungstag der Anmeldung: 06.06.2018
(73) Patentinhaber: Zollern BHW Gleitlager GmbH & CO. KG, 38124 Braunschweig (DE)
(72) Erfinder: GZOVSKYY, Kostyantyn, 38126 Braunschweig (DE); GUST, Edgar, 38302 Wolfenbüttel (DE)
(74) Vertreter: Lins, Martina
(86) Internationale Anmeldenummer: PCT/DE2016/100343
(87) Internationale Veröffentlichungsnummer: WO 2017/016551

(56) Entgegenhaltungen:
- EP-B1- 0 497 944
- DE-A1- 1 508 961
- DE-A1- 1 903 428
- DE-A1- 2 065 613
- DE-A1- 2 903 975

## Beschreibung

Die Erfindung betrifft ein Verfahren zur Herstellung eines Strangs aus einer aus mehreren Bestandteilen gebildeten monotektischen Legierung, in der im erstarrten Zustand in einer Kristallmatrix Tröpfchen einer Primärphase gleichmäßig verteilt sind.

Die Erfindung betrifft insbesondere eine monotektische Aluminium-Bismut-Legierung, insbesondere als Gleitlagerlegierung.

Hochbeanspruchte Gleitlager werden aus mehreren Schichten aufgebaut, um der Vielfalt der an die Lager gestellten und zum Teil gegenläufigen Anforderungen zu genügen. Derartige Gleitlager werden häufig mit Stahl-Aluminium-Verbundwerkstoffen aufgebaut.

Während eine Stahlstützschale die Aufnahme der mechanischen Beanspruchung und den Festsitz gewährleistet, müssen die Gleitlagerwerkstoffe den vielfältigen tribologischen Beanspruchungen widerstehen und ermüdungsfest sein. Um diese Anforderungen zu erfüllen, enthalten die Gleitlagerwerkstoffe eine beispielsweise aus Aluminium bestehende Kristallmatrix, in die harte Phasen, wie etwa Silizium und intermetallische Ausscheidungen, und andererseits weiche Phasen, wie z. B. Blei oder Zinn eingelagert sein können. Hochbelastbare Mehrschicht-Gleitlager besitzen häufig zusätzlich eine auf die durch den Gleitlagerwerkstoff gebildete Funktionsschicht galvanisch aufgebrachte Gleitschicht. Diese weiche Gleitschicht sorgt für gute Notlaufeigenschaften des Lagers und kann Abriebpartikel einbetten und so von der Gleitfläche entfernen.

Stranggießanlagen zur Herstellung eines flächigen Metallstrangs sind bekannt. DE 1 508 961 A und DE 1 903 428 A offenbaren die Herstellung eines Metallstrangs auf der Oberfläche einer Trommel, die so ausgebildet ist, dass sie zusammen mit einem anliegenden Gießband eine mantelseitig abgeschlossene Gießkammer bildet. Durch eine Kühlung der Trommel einerseits und des Gießbandes andererseits wird eine schnelle Erstarrung des Gießbandes bewirkt.

DE 29 03 975 A1 offenbart eine Variante, bei der der um die Trommel mit Hilfe eines Gießbandes herumgeführte und bereits an seinen Außenseiten verfestigte Metallstrang noch durch eine schräg ansteigende Kühlsektion geleitet wird, in der auch der noch geschmolzene Kern ausgehärtet wird.

EP 0 497 944 B1 beschreibt ein Verfahren zur Herstellung eines Lagerwerkstoffes, der sowohl die Stützeigenschaften als auch die Gleitlagereigenschaften aufweisen soll. Bei einer monotektischen Legierung mit eingelagerten tropfenförmigen Teilchen aus Blei als Weichphase wird eine Seigerung angestrebt, bei der die Tröpfchen sich nach unten verstärkt ansammeln und an der Oberseite verarmen. Es wird somit eine bewusst ungleichmäßige Verteilung der Weichphase über die Dicke der Legierung angestrebt, also keine gleichmäßige Verteilung, wie sie durch das eingangs erwähnte Verfahren erreicht werden soll.

Für Gleitlagerlegierungen spielen Umweltaspekte eine zunehmende Rolle. Als eine umweltfreundliche Alternative zu bleihaltigen Aluminiumgleitlagerlegierungen sind Gleitlager auf der Basis Aluminium-Zinn betrachtet worden, die ohne zusätzliche Gleitschicht eingesetzt werden. Den mechanischen Eigenschaften dieser Legierungen, beispielsweise Ermüdungsfestigkeit und Warmfestigkeit, sind jedoch Grenzen gesetzt. Der verhältnismäßig hohe Zinngehalt führt beim Gießen zur Bildung eines an den Korngrenzen zusammenhängenden Zinnnetzes, das die Belastbarkeit dieser Legierungen speziell bei höheren Temperaturen erheblich beeinträchtigt.

Es ist bekannt, dass im Vergleich zu Zinn Bismut als weiche Phase in der AluminiumMatrix Vorteile bietet. Bismut weist einen höheren Schmelzpunkt als Zinn auf und kann daher bei höheren Temperaturen eingesetzt werden. Durch spezielle Gieß- und Wärmebehandlungsmaßnahmen ist es möglich, eine massive Anreicherung des Bismuts an den Korngrenzen der Gleitlagerlegierung zu vermeiden und eine hinreichend gleichmäßige und feine Verteilung der Bismuttröpfchen im Gefüge zu erhalten. Die Aluminium-Bismut-Legierung bildet ein monotektisches Gefüge aus, in dem eine feine und gleichmäßige Verteilung der Bismuttröpfchen zu einer Verbesserung der Belastbarkeit und der tribologischen Eigenschaften gegenüber Aluminium-Zinn-Legierungen führt.

In DE 40 03 018 A1 wird eine Aluminiumlegierung beschrieben, die als Hauptlegierungselemente wahlweise Blei, Bismut oder Indium oder eine Kombination hiervon enthalten kann. Weiterhin soll zusätzlich eine oder mehrere Komponenten enthalten sein, die in beträchtlichen Anteilen von bis zu 20 Gew.% vorgesehen werden können, wie beispielsweise Silizium, Zinn, Zink, Magnesium und Kupfer. Die wesentliche Idee besteht dabei darin, die Legierung im Strangguss vertikal zu einem Band oder Draht zu vergießen und eine hohe Abkühlungsgeschwindigkeit von 300 bis 1.500 K/s vorzusehen. Durch die hohe Abkühlungsgeschwindigkeit soll verhindert werden, dass in der Zeit zwischen dem Unterschreiten der Entmischungstemperatur und der vollständigen Erstarrung des Matrixmetalls großvolumige Ausscheidungen einer Minoritätsphase gebildet werden. Aus der Praxis des Stranggießens von Aluminiumlegierungen ist es generell jedoch bekannt, dass infolge der sehr hohen Abkühlungsgeschwindigkeiten eine erhebliche Gefahr der Rissbildung besteht und die für die Serienfertigung erforderliche Prozessstabilität nur schwer zu gewährleisten ist. In dem einzigen offenbarten Ausführungsbeispiel enthält die Aluminiumlegierungsschmelze 5 % Bismut und 5 % Silizium. Der hohe Siliziumanteil führt dabei zu einer Verstärkung der Aluminiummatrix, hat jedoch einen negativen Einfluss auf die Größe der primären Bismutphase. Große Tröpfchen der Bismutphase werden durch anschließende Walzvorgänge zu sehr dicken Fäden verformt, die die mechanische Belastbarkeit und die tribologischen Eigenschaften des Werkstoffs erheblich herabsetzen.

EP 0 940 474 A1 offenbart eine monotektische Aluminiumgleitlagerlegierung mit einem Bismutanteil von 5 bis 15 Gew.% sowie wenigstens einem Hauptlegierungselement aus der Gruppe Silizium, Zinn und Blei mit einem Gesamtanteil von bis zu 15 Gew.%. Das einzige Ausführungsbeispiel besteht aus 8 Gew.% Bismut, 1 Gew.% Zinn und 4 Gew.% Silizium sowie 0,3 Gew.% Mangan als Nebenlegierungselement, Rest Aluminium. Für das vorgesehene Bandgießen dieser Legierung wird eine homogene Verteilung der Bismutphase durch intensives Rühren der Schmelze im elektromagnetischen Feld angestrebt. Eine Feinung des Gefüges soll durch Zugabe von nicht näher definierten Kornfeinungsmitteln möglich sein. Mit den Hauptlegierungselementen Zinn und Silizium als weiche bzw. harte Komponente werden die oben erwähnen Nachteile erhalten.

Ähnliches gilt für die aus EP 0 190 691 A1 bekannte Legierung mit 4 bis 7 Gew.% Bismut, 1 bis 4,5 Gew.% Silizium sowie zumindest einem Element aus der Gruppe Zinn, Zink und Antimon mit bis zu 5 Gew.%-Anteil, sowie optionalen weiteren Zusatzlegierungselementen. Die durch die Siliziumanteile verursachte Härtung der Aluminiummatrix bewirkt eine Vergrößerung der Tropfen der Primärphase wodurch beim nachfolgenden Walzen die erwähnten Nachteile entstehen.

Durch DE 40 14 430 A1 ist es bekannt, eine monotektische Aluminium-Silizium-Bismut-Legierung bei Temperaturen von 575°C bis 585°C einer Wärmebehandlung zu unterziehen, um eine feine Verteilung der nach dem Walzen plattenförmig gestreckten Bismutphase zu erreichen. Die Wärmebehandlung bietet ferner die Möglichkeit, die Festigkeitswerte der Aluminiumgleitlagerlegierung durch Aushärtungseffekte zu verbessern. Die zum Erzielen der möglichen Aushärtungseffekte geeigneten Elemente sind beispielsweise Silizium, Magnesium, Zink und Zirkonium. Die Zugabe von Kupfer erhöht die Aushärtungsrate und kann in Kombination mit diesen Elementen eingesetzt werden.

Aus US 5,286,445 ist eine Aluminiumgleitlagerlegierung mit einem Bismutgehalt von 2 bis 15 Gew.%, 0,05 bis 1 Gew.% Zirkonium sowie einem Kupfergehalt und/oder Magnesiumgehalt bis zu 1,5 Gew.% bekannt. Zusätzlich enthält diese Legierung zumindest ein Element aus der Gruppe Zinn, Blei und Indium in Summe von 0,05 bis 2 Gew.% oder zumindest ein Element aus der Gruppe Silizium, Mangan, Vanadium, Antimon, Niob, Molybdän, Kobalt, Eisen, Titan, Chrom in Summe von 0,05 bis 5 Gew.%. Die Zusätze an Zinn, Blei und Indium unterstützen die Rekoagulation von gestreckten Bismuttropfen zu feineren Ausscheidungen bei Temperaturen von 200°C bis 350°C. Die Elemente Zirkonium, Silizium und Magnesium bewirken nach dem Glühen im Temperaturbereich von 480°C bis 525°C, das kurz vor dem Walzplattiervorgang durchgeführt wird, den eigentlichen Härtungseffekt. Die Übergangselemente sollen eine zusätzliche Steigerung der mechanischen Belastbarkeit des Werkstoffes gewährleisten.

Die nachteilige Wirkung von Silizium tritt auch hier auf. Die Zugabe von Magnesium bringt zusätzlich den Nachteil mit sich, dass Magnesium mit Bismut bevorzugt die intermetallische Verbindung Mg3Bi2 bildet. Diese lagert sich in den Bismuttropfen ein und setzt die Einbettfähigkeit der Bismuttropfen für Abriebpartikel deutlich herab. Durch die Zinnzugabe wird die mechanische Belastbarkeit des Gleitlagerwerkstoffes bei höheren Temperaturen erheblich beeinträchtigt.

Alle vorstehend beschriebenen bismuthaltigen Legierungen haben bisher keine praktische Bedeutung erlangt, da die bei ihrer Herstellung durch Stranggießen und ihrer nachfolgenden Weiterverarbeitung zu einer Gleitlagerschale ablaufenden komplexen Vorgänge bis jetzt nicht in ausreichendem Maße beherrscht wurden. Als Voraussetzung für ein optimales Eigenschaftsprofil der Aluminiumgleitlagerlegierung ist neben der feinen Verteilung der Primärphase im Gusszustand insbesondere die Möglichkeit anzusehen, auch nach den notwendigen Umform- und Walzplattiervorgängen eine feine Verteilung der Primärphase herstellen zu können. Weitere Anforderungen sind eine hohe Festigkeit, mechanische Belastbarkeit, auch bei hohen Temperaturen, Verschleißbeständigkeit der Aluminiummatrix sowie eine gute Umformbarkeit.

US 2010/0221141 A1 offenbart eine siliziumfreie Legierung mit Hauptlegierungselementen Bismut, Kupfer und Zink. Der hohe Zinkgehalt führt zwar zu einer Vergröberung der primären Bismutphase, bewirkt jedoch nach dem Walzen und der Wärmebehandlung eine bedeutende Verkleinerung der Bismuteinschlüsse. Diese Erscheinung ist mit der hohen Diffusionsbeweglichkeit des Zinks in der Aluminiummatrix und der damit verbundenen Absenkung der Rekristallisierungstemperatur zu erklären. Die Bildung neuer kleiner Körner als Ersatz für die deformierten Körner führt zur Verkleinerung der Bismutteilchen. Die hohe Beweglichkeit des Zinks in der Aluminiummatrix verursacht allerdings eine vorzeitige Entfestigung und eine Ansammlung von Zink an den Korngrenzen. Hieraus resultiert eine lokale Versprödung der Korngrenzen und damit eine Senkung der Dauerfestigkeit des Gleitlagerwerkstoffs. Grundsätzlich ist es möglich, die hohe Diffusionsbeweglichkeit des Zinks in der Aluminiumlegierung durch Zulegieren von Magnesium zu verringern, weil sich das Magnesium mit Zink in die M-Phase (MgZn2) und in die T-Phase (Al2Mg2Zn3) verbindet. In bismuthaltigen Legierungen bildet sich allerdings - wie erwähnt - die unerwünschte Mg3Bi2-Phase.

Das anhand des monotektischen Aluminium-Bismut-Gefüges bestehende Problem gilt generell für monotektische Gefüge, in denen sich Tröpfchen einer Primärphase in einer auskristallisierenden Matrix verteilen, wobei eine feine und möglichst gleichmäßige Verteilung zur Erzielung günstiger Eigenschaften, beispielsweise tribologischer Eigenschaften, wünschenswert ist.

Der vorliegenden Erfindung liegt daher die Aufgabe zugrunde, mit einfachen Mitteln bei der Herstellung der monotektischen Legierung bereits eine gleichmäßige Verteilung der Tröpfchen der Primärphase in der auskristallisierten Matrix zu ermöglichen.

Die Lösung dieser Aufgabe gelingt erfindungsgemäß bei einem Verfahren der eingangs erwähnten Art mit den Verfahrensschritten:
a) Schmelzen der aus wenigstens einer Matrixkomponente und einer die Primärphase bildenden Komponente bestehenden Bestandteile der Legierung und Aufheizen auf eine Temperatur, bei der eine einzige homogene Phase existiert;
b) Transportieren der Schmelze in Strangform in einer eine Neigung gegen die Horizontale aufweisenden Transporteinrichtung mit einer Transportgeschwindigkeit;
c) Kühlung der Schmelze während des Transports von einer senkrecht zur Transportrichtung stehenden Unterseite der Strangform aus zur Ausbildung einer Kristallisationsfront beim Transport in einer Kühlzone;
d) Abstimmung der Kühlintensität, der Neigung der Transportrichtung und der Transportgeschwindigkeit derart, dass sich eine horizontale Kristallisationsfront ausbildet und dass die sich bei der durch die Abkühlung und die Ausbildung der Primärphase in Form von Tröpfchen entstehende Marangonikraft antiparallel zur Gravitationskraft gerichtet ist, sodass die Bewegung der Tröpfchen der Primärphase in der Matrixkomponente in Richtung der Gravitationskraft erfolgt;
e) Abzug der zum Strang erstarrten Legierung aus der Kühlzone.

Die erfindungsgemäß verwendete Kühlintensität ist von der Neigung der Transportrichtung und der Transportgeschwindigkeit abhängig, sollte aber bevorzugt eine Abkühlgeschwindigkeit der Kühleinheit zwischen 1 und 1000 K/s, vorzugsweise zwischen 200 und 600 K/s, aufweisen.

Vorzugsweise wird der Legierung wenigstens ein Kornfeinungsmittel zugesetzt. Die Zugabe an Kornfeinungsmittel kann zumindest verringert werden, wenn der Schmelze eine keimhaltige Vorlegierung zugesetzt wird.

Bevorzugt wird mit der Erfindung eine Gleitlagerlegierung hergestellt, die insbesondere eine Aluminium-Bismut-Legierung ist. Diese Legierung kann bis zu 3 Gew.% Al-Ti-B oder Al-Ti-C als Kornfeinungsmittel enthalten.

Es hat sich als sinnvoll herausgestellt, wenn die Neigung der Transportrichtung beim Abkühlen der Schmelze relativ zur Horizontalen auf 1 bis 60°, vorzugsweise auf 10 bis 30°, eingestellt wird. Insbesondere kann die Neigung im Bereich der Kühlzone als ein Kreisbogenabschnitt ausgebildet sein, der sich vorzugsweise über einen Viertelkreis erstreckt.

Die vorliegende Erfindung beruht auf folgenden Erkenntnissen und Sachverhalten, die anhand der Zeichnungsfiguren erläutert werden. Es zeigen:
- Figur 1: ein Zustandsdiagramm für eine Aluminium-Bismut-Legierung;
- Figur 2: eine schematische Darstellung des Abkühlvorgangs für ein Standgussverfahren mit einer Abkühlung von der Unterseite;
- Figur 3: eine schematische Darstellung des Abkühlverhaltens bei einem Standgussverfahren mit einer von Seitenwänden ausgehenden Kühlung;
- Figur 4: eine schematische Darstellung des Abkühlverhaltens bei einem herkömmlichen Stranggussverfahren mit einem Transport der Schmelze in lotrechter Richtung;
- Figur 5: eine schematische Darstellung des Abkühlverhaltens für ein Stranggussverfahren mit einem horizontalen Transport der Schmelze;
- Figur 6: eine schematische Darstellung des Abkühlverhaltens bei einem erfindungsgemäßen Stranggussverfahren;
- Figur 7: ein Ausführungsbeispiel für eine Vorrichtung zur Durchführung des erfindungsgemäßen Stranggussverfahrens;
- Figur 8: ein Schliffbild eines Gussgefüges einer ersten bevorzugten Gleitlagerlegierung;
- Figur 9: ein Schliffbild eines Gussgefüges einer zweiten bevorzugten Gleitlagerlegierung.

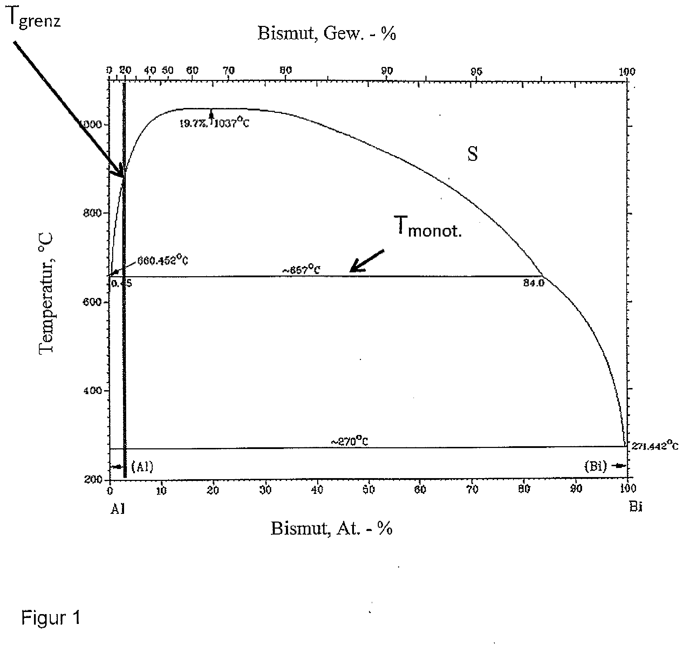

Monotektische Systeme sind dadurch gekennzeichnet, dass sie im flüssigen Zustand eine Mischungslücke aufweisen. Der Grund für eine Entmischung im flüssigen Zustand liegt hauptsächlich in den sehr großen Atomradiendifferenzen und Atomgewichtsdifferenzen, welche die Störung der Struktur- und Bindungsverhältnisse auch im flüssigen Zustand verursachen. Die Mischungslücke ist durch eine Grenztemperatur T_{grenz} charakterisiert, die in dem als Figur 1 beigefügten Zustandsdiagramm für eine Aluminium-Bismut-Legierung bei ca. 880°C eingezeichnet ist. Oberhalb dieser Grenztemperatur T_{grenz}, also oberhalb der Mischungslücke, sind monotektische Legierungen einphasig, bestehen also nur aus einer einzigen Schmelze. Unterhalb der Grenztemperatur T_{grenz} bildet sich aus der homogenen Schmelze beim Abkühlen eine Primärphase aus primärem Bismut. Die Aluminiummatrix liegt hierbei noch in flüssiger Form vor. Die noch flüssige Matrix enthält einen geringen Anteil Bismut in gelöster Form. Bei Erreichen der Temperatur Tₘₜ für die monotektische Umwandlung bei 657°C sind in der noch vollständig flüssigen Aluminiummatrix 0,45 at.% Bi enthalten. Unterhalb der Temperatur Tₘₜ erstarrt die Matrix allmählich zu reinem Aluminium, wobei sich in der geringer werdenden Flüssigkeit Bismut anreichert bis zu einer Zusammensetzung Al + 84 at.% Bi. Diese Flüssigkeit wandelt sich bei der Temperatur von 270°C in reines Aluminium und reines Bismut um. Dieses Bismut ist ein sekundäres Bismut, da es aus einer Sekundärphase entstanden ist.

Die Schmelze kann weitere sekundäre Phasen aufweisen, beispielsweise CuAl2, Al12Mn, Al6Mn, Al3Zr sowie das bereits erwähnte monotektische (sekundäre) Bi.

Beim Ausfallen der Primärphase aus der Schmelze beginnen sich die Dichteunterschiede zwischen Aluminium (ρ= 2,7 g/cm²) und Bismut (ρ=9,78 g/cm²) bemerkbar zu machen. Auch die Schmelzanteile weisen eine merkliche Dichtedifferenz auf, wodurch eine Schwerkraftseigerung auftritt. Die spezifisch schwerere bismutreiche Schmelze wird auf den Boden des Schmelzgefäßes sinken, die leichtere, aluminiumreiche Schmelze sich darüber anordnen.

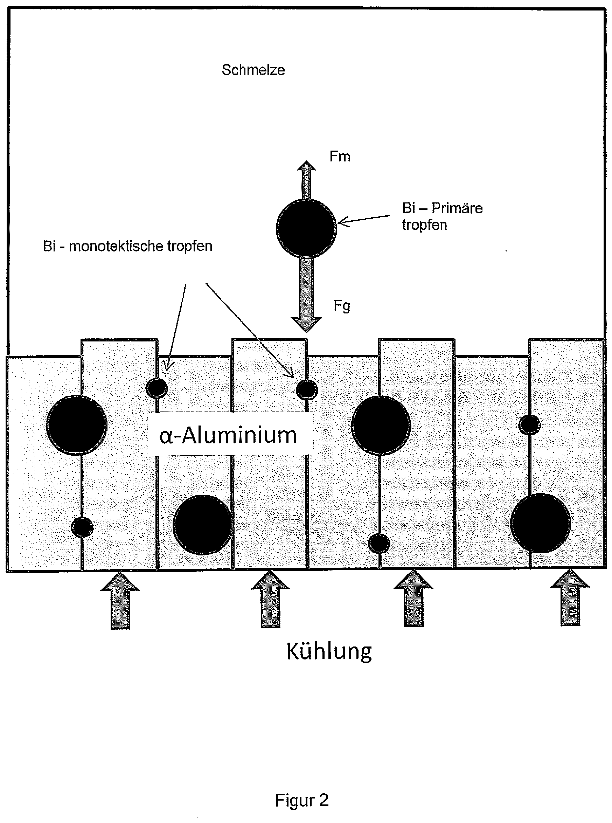

Zusätzlich wird der Wachstumsprozess der ausgeschiedenen Tropfen der Primärphase durch deren Beweglichkeit in der flüssigen Matrix beeinflusst. Die beim Unterschreiten der Entmischungstemperatur ausgeschiedenen Tropfen der Primärphase bewegen sich aufgrund der Temperaturabhängigkeit der Grenzflächenspannung im Temperaturfeld der Probe. Diese sogenannte Marangoni-Bewegung erfolgt in Richtung der höchsten Temperatur entgegengesetzt zum steilsten Temperaturgradienten. Da die Geschwindigkeit der Marangoni-Bewegung proportional zur Größe der Tropfen ist, können sich die größeren Tropfen schneller als die kleineren bewegen und ggf. die kleineren Tropfen zur Ausbildung noch größerer Tropfen aufnehmen. Die Marangoni-Driftgeschwindigkeit ist proportional zum Radius sowie zum Temperatur- und Konzentrationsgradienten. Auf die Tropfen der Primärphase wirkt zusätzlich die Gravitationskraft, sodass sich eine Bewegung der Tropfen der Primärphase in der flüssigen Matrix ergibt, die aus einer vektoriellen Addition der Gravitationskraft Fg und der Marangonikraft Fm ergibt. Dies wird anhand der Figuren 2 bis 4 für herkömmliche Gießverfahren verdeutlicht.

Figur 2 betrifft eine unbewegte Schmelze, also ein Standgussverfahren. Die Abkühlung erfolgt von der Unterseite eines Schmelzbehälters aus, sodass sich eine horizontale Kristallisationsfront der in dem dargestellten Beispiel durch Aluminium gebildeten Matrix nach oben bewegt. Auf die ausgeschiedenen Tropfen der in dem Beispiel durch Bismut (Bi) gebildeten Primärphase wirkt die Gravitationskraft nach unten und die Marangonikraft nach oben ein. Da die Gravitationskraft größer als die Marangonikraft ist, entsteht eine lotrechte resultierende Kraft, die senkrecht auf der Kristallisationsfront steht und die Tropfen gegen die Kristallisationsfront (Erstarrungsfront) drückt. Die hier aus Bismut bestehenden Tropfen werden durch die in Richtung der Gravitationskraft Fg verlaufende resultierende Kraft gegen die Erstarrungsfront gedrückt und bleiben daher in gleichmäßiger Verteilung in der Aluminiummatrix.

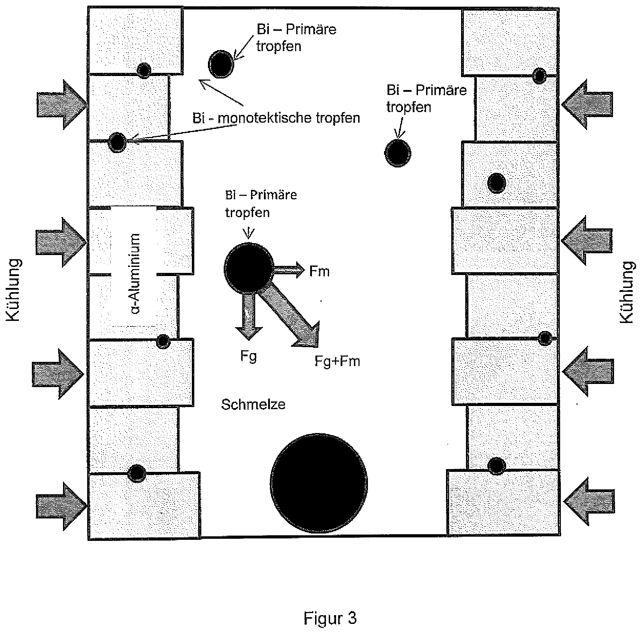

Bei dem in Figur 3 dargestellten Beispiel eines herkömmlichen Gießverfahrens handelt es sich ebenfalls um ein Standgussverfahren, bei dem die Schmelze nicht bewegt wird. Im Unterschied zu dem Beispiel gemäß Figur 2 erfolgt die Kühlung jedoch nicht über eine Bodenfläche, sondern über lotrecht stehende Seitenflächen des Gießbehälters, sodass sich die Kristallisationsfront von den Seitenflächen nach innen bewegt, wie dies in der Zeichnung durch die schematisch dargestellten Frontabschnitte verdeutlicht ist. Auf die Tropfen der Primärphase wirkt die Gravitationskraft Fg in lotrechter Richtung, während die Marangonikraft Fm in diesem Fall horizontal gerichtet ist. Hieraus ergibt sich eine resultierende Kraft Fg+Fm, die schräg nach unten gerichtet ist, sodass die Tropfen nicht durch die Gravitationskraft gegen die Erstarrungsfront gedrückt werden, sondern sich im Wesentlichen zum Boden des Gießbehälters bewegen. Die Bismuttropfen werden daher nicht gleichmäßig verteilt und es entstehen Seigerungen. Da die Bewegung der Tropfen im Wesentlichen zum Boden des Gießgefäßes gerichtet ist, haben die Tropfen auch eine lange Verweildauer in der Schmelze, die nicht vom Boden aus erstarrt, sondern von den Seitenwänden aus. Hierdurch kommt es zu einer Vergrößerung der Tropfen, wenn diese sich mit kleineren (und langsameren) Tropfen vereinigen.

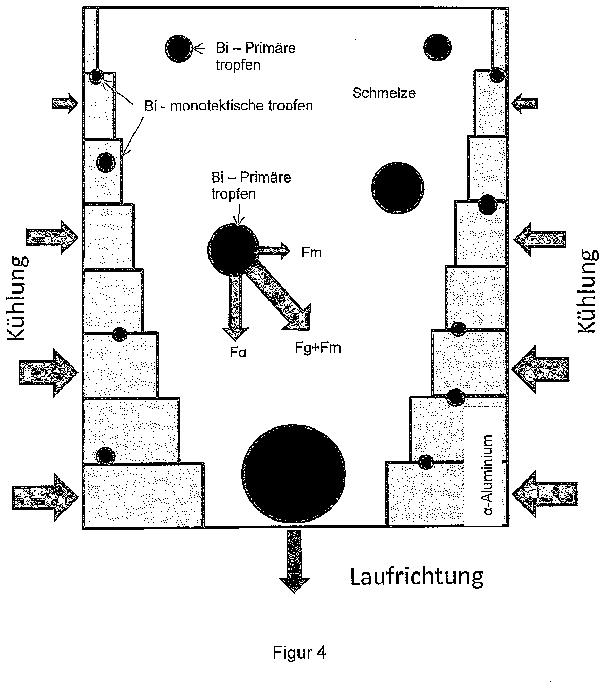

Figur 4 zeigt schematisch die Verhältnisse für ein Stranggussverfahren, bei dem sich die Schmelze in Richtung der Gravitationskraft, also lotrecht nach unten, bewegt. Die Abkühlung erfolgt in diesem Fall von den Seiten des Stranges, also senkrecht zur Laufrichtung der Legierung. Auch hier steht die Marangonikraft Fm senkrecht zur Gravitationskraft Fg, sodass sich eine Bewegung der Tropfen der Primärphase ergibt, die im Wesentlichen nicht gegen die voranschreitende Erstarrungsfront gerichtet ist. Demgemäß entstehen auch hier Seigerungen und vergrößerte Tropfen, also keine Feinverteilung der Primärphase in der erstarrten Matrix.

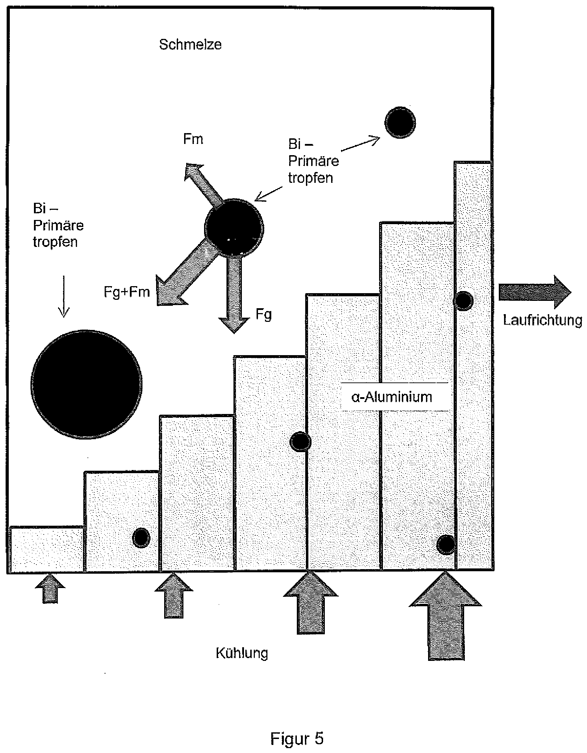

Ein ähnliches Bild ergibt sich gemäß Figur 5 für den Fall eines Stranggussverfahrens, bei dem die Abkühlung von der Unterseite entgegen der Gravitationskraft erfolgt. Die Marangonikraft ist in diesem Fall in Richtung des größten Temperaturgradienten ausgerichtet und verläuft schräg nach oben gerichtet, von der sich in Laufrichtung vergrößernden Erstarrungsfront wegzeigend. Die Bewegungsrichtung der Tropfen der Primärphase verläuft somit zum Bereich der noch nicht erstarrten Schmelze hin, sodass die Verweilzeit der Tropfen der Primärphase in der Schmelze groß ist. In der Folge entstehen auch hier Seigerungen und große Tropfen, die einer Feinverteilung entgegenstehen.

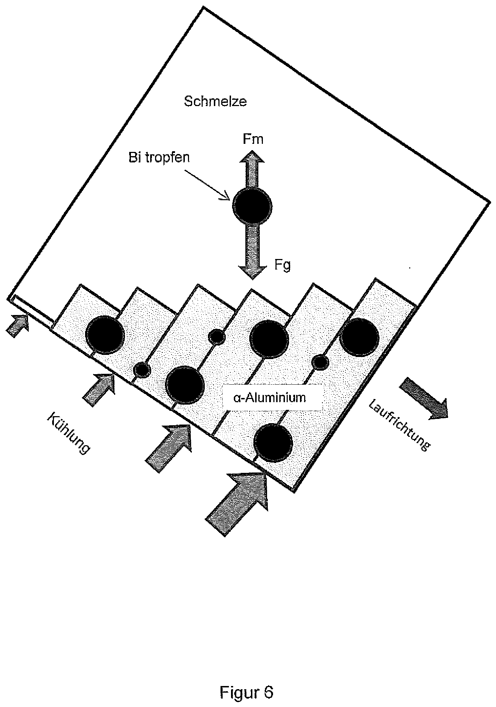

Das erfindungsgemäße Verfahren ist in Figur 6 schematisch dargestellt. Es handelt sich um ein Stranggussverfahren, bei dem die Schmelze in Form eines Strangs unter einem Neigungswinkel zur Gravitationskraft bewegt wird. Die Abkühlung erfolgt senkrecht zur Bewegungsrichtung der Schmelze. Es bildet sich eine Erstarrungsfront der Matrix aus, die mit zunehmenden Laufweg zunimmt. Die Kühlung und der Transport der Schmelze sind dabei so aufeinander abgestimmt, dass sich über den Laufweg eine im Wesentlichen horizontale Kristallisationsfront bildet. Da der größte Temperaturgradient von der (horizontalen) Kristallisationsfront weg zeigend entsteht, zeigt die Marangonikraft Fm von der horizontalen Kristallisationsfront, also von der Lotrechten, weg. Die Gravitationskraft liegt hingegen in der Lotrechten und überwiegt die Marangonikraft, sodass die Tropfen der Primärphase (hier: Bismut) mit einer resultierenden Kraft in Richtung der Gravitationskraft Fg gegen die sich im Wesentlichen horizontal ausbildende Kristallisationsfront gedrückt werden. Die Tropfen der Primärphase werden daher mit einer minimalen Verweilzeit in der flüssigen Schmelze von der auskristallisierenden Matrix aufgenommen und verbleiben daher feinverteilt in der Matrix (hier: Aluminiummatrix). Durch die erfindungsgemäße Maßnahme, die Schmelze unter einem Neigungswinkel zur Horizontalen zu transportieren und von der Unterseite der Strangform zu kühlen, ist es daher möglich, bereits durch die Stranggießvorrichtung eine feine und homogene Verteilung der Tropfen der Primärphase in der auskristallisierten Matrix, also beispielsweise eine feinverteilte Aluminium-Bismut-Legierung, zu erreichen.

Für die Erfindung ist es wesentlich festzustellen, dass der Transportweg für die Strangform der Schmelze nicht geradlinig verlaufen muss, dass also die Neigung nicht konstant sein muss. Vielmehr kann es sinnvoll sein, über den Transportweg die Neigung zunehmen zu lassen, um so der beschleunigt fortschreitenden Erstarrungsfront Rechnung zu tragen.

Soweit in den obigen Erläuterungen die Begriffe "horizontal", "lotrecht" und "senkrecht zueinander" verwendet worden sind, müssen der Natur der Sache nach keine mathematisch korrekten geometrischen Verhältnisse erfüllt sein. Vielmehr sind diese Begriffe als Angaben mit Toleranzen zu verstehen, deren zulässige Größe der Fachmann ohne weiteres bestimmen kann, um den erfindungsgemäßen Erfolg einer seigerungsfreien Gefügestruktur für die monotektische Legierung zu erreichen. Insbesondere werden Seigerungen in einem merklichen Ausmaß bereits dann vermieden, wenn die sich bildende Kristallisationsfront mit der Horizontalen einen kleinen Winkel von beispielsweise +/- 30 Grad einschließt.

Auch die Transportgeschwindigkeit der Transporteinrichtung für die Schmelze in Strangform muss nicht konstant sein, sondern kann über den Transportweg variieren. Es ist ferner möglich, den Strang nach dem Erstarren nicht kontinuierlich abzuziehen, sondern intermittierend zu arbeiten, um so eine Abkühlung nach dem Erstarren des Gefüges in definierter Form oder auch eine anschließende Wärmebehandlung zu ermöglichen.

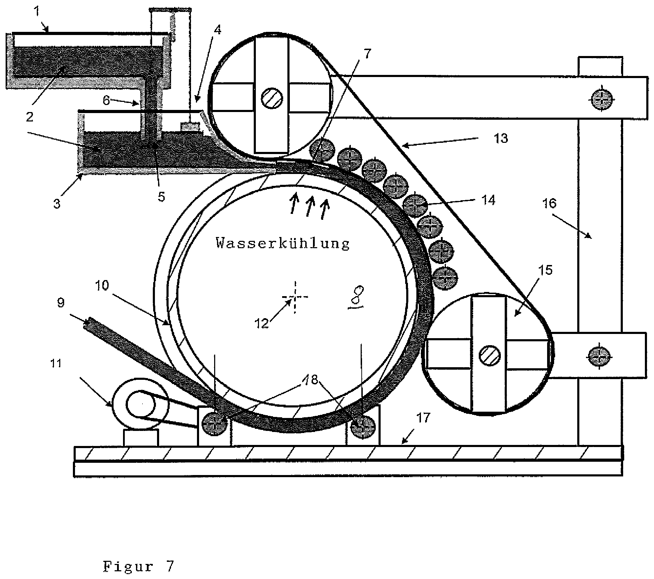

Ein Ausführungsbeispiel einer erfindungsgemäßen Vorrichtung ist in Figur 7 dargestellt.

Aus einem Vorratsbehälter 1 fließt eine Schmelze 2 der Legierung in einen darunter angeordneten Dosierbehälter 3, in dem die Schmelze 2 auf einem vorbestimmten Pegel gehalten wird. Hierzu dient ein Schwimmer 4 auf der Schmelze 2 in dem Dosierbehälter 3, der mit einem Schließventil 5 in einem Zulauf 6 aus dem Vorratsbehälter 1 in den Dosierbehälter 3 verbunden ist. Der Dosierbehälter 3 weist einen rechteckigen Auslauf 7 auf, aus dem die Schmelze in Form eines rechteckigen Strangs in zähflüssiger Form austritt. Der Auslauf 7 mündet an der höchsten Stelle einer Hohlwalze 8, auf deren Mantelfläche der aus dem Dosierbehälter 3 austretende Strang geführt wird. Die Hohlwalze 8 weist einen wassergekühlten Mantel 10 auf, der beispielweise aus Kupfer bestehen kann. Aufgrund der Kühlung verfestigt sich die aus dem Auslauf 7 austretende Schmelze in der beschriebenen erfindungsgemäßen Weise schnell zu dem Strang 9, der über etwas mehr als den halben Umfang der Hohlwalze auf der Mantelfläche geführt und dann abgezogen wird. Hierzu wird die Hohlwalze 8 durch einen Getriebemotor 11 über Lagerrollen 18 in Rotation um seine Mittenachse 12 versetzt, sodass die Schmelze bzw. der Strang 9 keine Relativbewegung zur Mantelfläche der Hohlwalze 8 ausführen muss. Auf dem ersten Quadranten der Mantelfläche wird die Schmelze 9 bzw. der sich verfestigende Strang auf der Oberseite der Mantelfläche durch einen Trum eines endlos umlaufenden Stahlbands 13 geführt. Dieser Trum des Stahlbands 13 wird mittels einer Vielzahl von Andruckrollen 14 mit einem definierten Druck gegen die Mantelfläche der Hohlwalze 8 gedrückt, sodass auf den Strang 9 eine formende und transportierende Kraft über das Stahlband 13 ausgeübt wird. Das Stahlband 13 wird mittels einer Antriebsrolle 15 mit einer solchen Geschwindigkeit angetrieben, dass sich der Trum des Stahlbands 13 ohne Relativgeschwindigkeit zur Mantelfläche der Hohlwalze 8 bewegt.

Die gesamte Vorrichtung befindet sich an einem Traggestell 16, das starr auf einem Fundament 17 befestigt ist.

Die Darstellung der Figur 7 ist aus Übersichtsgründen schematisiert. Details, wie beispielsweise die Wasserkühlung des Mantels 10 und der Antrieb und die Geschwindigkeitsregelung des Stahlbands 13 sind dem Fachmann bekannt und aus Gründen der Übersichtlichkeit nicht dargestellt.

### Beispiel 1

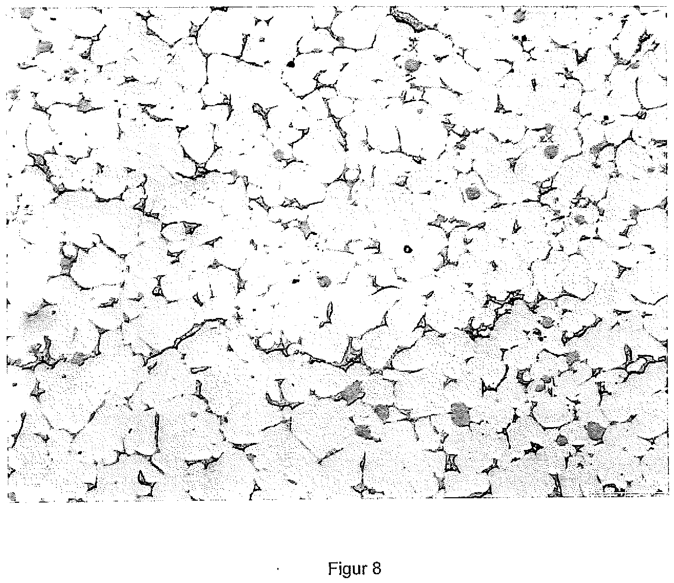

Figur 8 zeigt das Gussgefüge einer als ein bevorzugtes Ausführungsbeispiel ausgeführten AlCu4Bi6TiZrMn-Gleitlagerlegierung. Die dunkel dargestellte Bismutphase liegt tropfenförmig vor. Die Tropfen haben einen Durchmesser von maximal etwa 10 µm. Die Herstellung des Gussgefüges aus Figur 8 erfolgte mit der Vorrichtung gemäß Figur 7. Dabei wurde der Strang 9 mit einem Querschnitt von 10 mm x 220 mm abgezogen. Für die Herstellung eines Gleitlagers wurde der Strang 9 anschließend gebürstet. Ein entfetteter Haftvermittler aus einer Aluminiumlegierung wurde auf den gebürsteten und entfetteten Strang mit einem ersten Walzstich in einem Walzgerüst aufplattiert. Die Dicke des plattierten Vormaterialbandes lag bei 4 mm. Dieses wurde anschließend auf 1,3 mm in fünf Walzstichen abgewalzt. Um die Plattierfähigkeit des Aluminium-Lager-Werkstoffbandes zu verbessern, wurde es einer Erholungsglühung bei 370°C in einer Dauer von bis zu 3 Stunden unterzogen. Beim nächsten Verarbeitungsschritt wurden ein Stahlband als Trägermaterial des Gleitlagers und das Aluminium-Lagerwerkstoffband in einem Plattierwalzwerk miteinander verbunden. Anschließend wurde die erzeugte Werkstoffverbindung einer drei Stunden dauernden Wärmebehandlung bei einer Temperatur von 360°C unterzogen, wobei die Bindung zwischen dem Stahl und dem Aluminiumlagerwerkstoff durch einen Diffusionsprozess gesteigert wird und die nach dem Plattieren in der Aluminium-Kupfer-Matrix der Gleitlagerlegierung stark gestreckten Bismutfäden zu feinen, bis zu 25 µm großen kugelförmigen Tropfen vollständig umgebildet. Aus der Wärmevorbehandlung resultierte eine große Härte von über 42 HB 2,5/62,5/30. Nach der Wärmebehandlung kann das plattierte Band unterteilt und zu Gleitlagerschalen geformt werden.

### Beispiel 2

Zur Herstellung des Gleitlagerwerkstoffs werden gemäß einer weiteren bevorzugten Ausführungsform an einer Stranggießanlage gemäß Figur 7 Gussbänder mit einem Querschnitt 10 mm x 220 mm erzeugt. 5 Min. vor dem Gießen wird eine 1% AlTi3C0,15 Vorlegierung zu der Legierung AlCu4Bi6TiMnCr in den Tiegel (Dosierbehälter 3) zugeführt und die Schmelze wird intensiv gemischt. Der hergestellte und erfindungsgemäß abgekühlte Strang wird gebürstet und entfettet. Auf den Strang wird ein gebürsteter und entfetteter Haftvermittler aus einer Aluminiumlegierung mit einem ersten Walzstich aufplattiert. Die Dicke des plattierten Vormaterialbandes liegt bei 4 mm. Dieses wird anschließend auf 1,3 mm in mehreren Walzstichen abgewalzt. Hierzu werden fünf Walzstiche benötigt. Um die Plattierfähigkeit des Aluminium-Lager-Werkstoff-bandes zu verbessern, wird dieses einer Erholungsglühung bei 370 °C von bis zu drei Stunden Dauer unterzogen. Im nächsten Verarbeitungsschritt werden ein Stahlband und das Aluminium-Lagerwerkstoffband in einem Plattierwalzwerk miteinander verbunden.

Anschließend wird die erzeugte Werkstoffverbindung einer drei Stunden andauernden Wärmebehandlung bei einer Temperatur von 360°C unterzogen, wobei die Bindung zwischen dem Stahl und dem Aluminium-Lagerwerkstoff durch einen Diffusionsprozess gesteigert wird und die nach dem Plattieren in der Aluminium-Kupfer-Matrix stark gestreckten Bismutfäden zu feinen bis zu 32 µm großen kugelförmigen Tropfen vollständig umgebildet werden. Die ebenfalls aus der Wärmebehandlung resultierende hohe Härte von wenigstens 38 HB 2,5/62,5/30 wirkt sich vorteilhaft aus. Nach dieser Wärmebehandlung kann das plattierte Band unterteilt und zu Lagerschalen eingeformt werden.

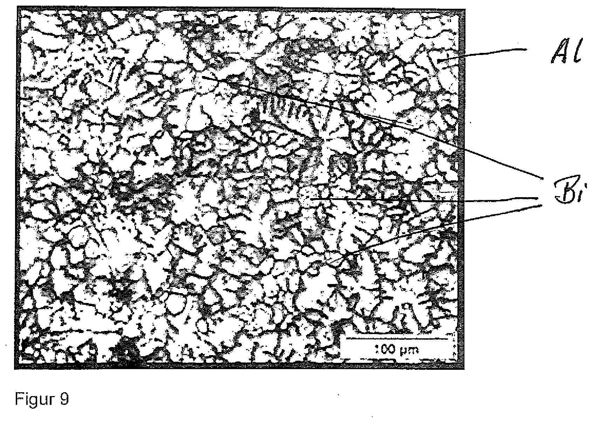

Figur 9 zeigt das Gefüge der Legierung nach der Herstellung durch das Gießen. Deutlich erkennbar ist die tropfenförmige primäre Bismutphase, die gleichmäßig verteilt in der Aluminiummatrix eingebettet ist. Überraschenderweise führt die Verwendung der Vorlegierung gemäß diesem Beispiel dazu, dass auf Zirkon als Kornfeinungsmittel verzichtet werden kann.

Die Beschreibung der Herstellung des Gleitlagers mit der erfindungsgemäßen Gleitlagerlegierung erfolgt lediglich beispielhaft, da dem Fachmann die Herstellungsschritte für ein Gleitlager mit einer im Stranggussverfahren gebildeten Legierung bekannt ist und ihm alle möglichen Variationen geläufig sind, die für die Benutzung der erfindungsgemäßen Legierung anwendbar sind.

## Patentansprüche

1. Verfahren zur Herstellung eines Strangs (9) aus einer aus mehreren Bestandteilen gebildeten monotektischen Legierung, in der im erstarrten Zustand in einer Kristallmatrix Tröpfchen einer Primärphase gleichmäßig verteilt sind, **gekennzeichnet durch** folgende Verfahrensschritte:
a) Schmelzen der aus wenigstens einer Matrixkomponente und einer die Primärphase bildenden Komponente bestehenden Bestandteile der Legierung und Aufheizen auf eine Temperatur, bei der eine einzige homogene Phase existiert;
b) Transportieren der Schmelze (2) in Strangform in einer eine Neigung gegen die Horizontale aufweisenden Transporteinrichtung mit einer Transportgeschwindigkeit;
c) Kühlung der Schmelze (2) während des Transports von einer senkrecht zur Transportrichtung stehenden Unterseite der Strangform aus zur Ausbildung einer Kristallisationsfront beim Transport in einer Kühlzone;
d) Abstimmung der Kühlintensität, der Neigung der Transportrichtung und der Transportgeschwindigkeit derart, dass sich eine horizontale Kristallisationsfront ausbildet und dass die sich bei der durch die Abkühlung und die Ausbildung der Primärphase in Form von Tröpfchen entstehende Marangonikraft antiparallel zur Gravitationskraft gerichtet ist, sodass die Bewegung der Tröpfchen der Primärphase in der Matrixkomponente in Richtung der Gravitationskraft erfolgt;
e) Abzug der zum Strang (9) erstarrten Legierung aus der Kühlzone.

2. Verfahren nach Anspruch 1, **dadurch gekennzeichnet, dass** eine Abkühlungsgeschwindigkeit in der Kühleinheit zwischen 1 und 1000 K/s, vorzugsweise zwischen 200 und 600 K/s, eingestellt wird.

3. Verfahren nach Anspruch 1 oder 2, **dadurch gekennzeichnet, dass** der Schmelze eine keimhaltige Vorlegierung zugesetzt wird.

4. Verfahren nach einem der Ansprüche 1 bis 3, **dadurch gekennzeichnet, dass** es zur Herstellung einer Gleitlagerlegierung verwendet wird.

5. Verfahren nach Anspruch 4, **dadurch gekennzeichnet, dass** die Gleitlagerlegierung eine Aluminium-Bismut-Legierung ist.

6. Verfahren nach Anspruch 5, **dadurch gekennzeichnet, dass** die Legierung bis zu 3 Gew.% Al-Ti-B oder Al-Ti-C als Kornfeinungsmittel enthält.

7. Verfahren nach einem der Ansprüche 1 bis 6, **dadurch gekennzeichnet, dass** die Neigung der Transportrichtung beim Abkühlen der Schmelze relativ zur Horizontalen auf 1 bis 60°, vorzugsweise auf 10 bis 30° eingestellt wird.

## Claims

1. A method for producing a strand (9) from a monotectic alloy which is formed from a plurality of constituents and in which droplets of a primary phase are uniformly distributed in a crystalline matrix in the solidified state, **characterized by** the following method steps:
a) melting the alloy constituents, which consist of at least one matrix component and a component that forms the primary phase, and heating the constituents to a temperature at which a single homogeneous phase exists;
b) transferring the melt (2) in strand form in a transfer unit that slopes with respect to the horizontal at a transfer speed;
c) cooling the melt (2) from a lower side of the strand, which is perpendicular to the transfer direction, during transfer in order to form a crystallization front during transfer in a cooling zone;
d) matching the cooling intensity, the slope of the transfer direction and the transfer speed in such a way that a horizontal crystallization front is formed and that the Marangoni force produced by the cooling and formation of the primary phase in the form of droplets is oriented anti-parallel to the gravitational force, with the result that the droplets of the primary phase in the matrix component move in the direction of the gravitational force;
e) withdrawing the alloy, which has solidified into the strand (9), from the cooling zone.

2. The method as claimed in claim 1, **characterized in that** a cooling rate in the cooling unit is set to between 1 and 1000 K/s, preferably between 200 and 600 K/s.

3. The method as claimed in claim 1 or 2, **characterized in that** a master alloy containing seed crystals is added to the melt.

4. The method as claimed in one of claims 1 to 3, **characterized in that** it is used to produce a plain bearing alloy.

5. The method as claimed in claim 4, **characterized in that** the plain bearing alloy is an aluminum-bismuth alloy.

6. The method as claimed in claim 5, **characterized in that** the alloy contains up to 3% by weight of Al-Ti-B or Al-Ti-C as a grain refiner.

7. The method as claimed in one of claims 1 to 6, **characterized in that** the slope of the transfer direction during the cooling of the melt relative to the horizontal is set to 1 to 60°, preferably to 10 to 30°.

## Revendications

1. Procédé de réalisation d'une barre continue (9) en un alliage monotectique formé de plusieurs constituants, alliage dans lequel, dans l'état figé, des gouttelettes d'une phase primaire sont réparties régulièrement dans une matrice cristalline, **caractérisé par** les étapes de procédé suivantes consistant à :
a) faire fondre les constituants de l'alliage formés par au moins une composante matricielle et par une composante formant la phase primaire, et les chauffer à une température à laquelle il existe une seule phase homogène ;
b) transporter l'alliage en fusion (2) sous forme de barre continu à une vitesse de transport dans un dispositif de transport présentant une inclinaison par rapport à l'horizontale ;
c) refroidir l'alliage en fusion (2) pendant le transport à partir de la face inférieure de la forme en barre continu perpendiculaire à la direction de transport, en vue de réaliser un front de cristallisation lors du transport dans une zone de refroidissement ;
d) ajuster l'intensité de refroidissement, l'inclinaison du dispositif de transport et la vitesse de transport, de telle sorte qu'il se forme un front de cristallisation horizontal et que la force de Marangoni qui résulte du refroidissement et de la réalisation de la phase primaire sous forme de gouttelettes est dirigée de façon antiparallèle à la force de gravitation, de sorte que le mouvement des gouttelettes de la phase primaire dans la composante matricielle s'effectue en direction de la force de gravitation ;
e) enlever l'alliage figé en barre continue (9) hors de la zone de refroidissement.

2. Procédé selon la revendication 1, **caractérisé en ce qu'**une vitesse de refroidissement entre 1 et 1000 K/s, de préférence entre 200 et 600 K/s, est réglée dans l'unité de refroidissement.

3. Procédé selon la revendication 1 ou 2, **caractérisé en ce qu'**un alliage précurseur contenant des germes est ajouté à l'alliage en fusion.

4. Procédé selon l'une des revendications 1 à 3, **caractérisé en ce qu'**il est utilisé pour réaliser un alliage pour palier lisse.

5. Procédé selon la revendication 4, **caractérisé en ce que** l'alliage pour palier lisse est un alliage d'aluminium et de bismuth.

6. Procédé selon la revendication 5, **caractérisé en ce que** l'alliage contient jusqu'à 3 % en poids de Al-Ti-B ou de Al-Ti-C à titre d'agent d'affinage des grains.

7. Procédé selon l'une des revendications 1 à 6, **caractérisé en ce que** l'inclinaison du dispositif de transport pendant le refroidissement de l'alliage en fusion par rapport à l'horizontale est réglée à une valeur de 1 à 60°, de préférence de 10 à 30°.
